(19) Europäisches Patentamt
European Patent Office
Office européen des brevets

(11) **EP 1 726 967 B1**

(12) **EUROPÄISCHE PATENTSCHRIFT**

(45) Veröffentlichungstag und Bekanntmachung des Hinweises auf die Patenterteilung:
**10.10.2018 Patentblatt 2018/41**

(51) Int Cl.:
***G01R 15/18*** *(2006.01)*

(21) Anmeldenummer: **06010079.9**

(22) Anmeldetag: **16.05.2006**

(54) **Verfahren und Vorrichtung zur Messung eines in einem elektrischen Leiter fliessenden Stroms**

Method and device for measuring a current flowing in an electric conductor

Procédé et dispositif destinés à mesurer un courant passant dans un conducteur électrique

(84) Benannte Vertragsstaaten:
FR GB

(30) Priorität: **25.05.2005 DE 102005024075**

(43) Veröffentlichungstag der Anmeldung:
**29.11.2006 Patentblatt 2006/48**

(73) Patentinhaber: **Epcos AG**
**81671 München (DE)**

(72) Erfinder:
• **Hausperger, Christian**
**84155 Bonbruck (DE)**
• **Kindler, Edgar**
**84036 Landshut (DE)**
• **Erckert, Ricardo**
**83043 Bad Aibling (DE)**
• **Röllgen, Bernhard**
**35576 Wetzlar (DE)**

(74) Vertreter: **Epping - Hermann - Fischer**
**Patentanwaltsgesellschaft mbH**
**Postfach 20 07 34**
**80007 München (DE)**

(56) Entgegenhaltungen:
WO-A-2005/005998    DE-A1- 4 229 948
US-A- 3 482 163    US-A- 5 475 301

• **PATENT ABSTRACTS OF JAPAN Bd. 014, Nr. 062 (E-0883), 5. Februar 1990 (1990-02-05) & JP 01 281715 A (FUJI ELECTRIC CO LTD), 13. November 1989 (1989-11-13)**
• **PATENT ABSTRACTS OF JAPAN Bd. 015, Nr. 418 (P-1266), 23. Oktober 1991 (1991-10-23) & JP 03 170873 A (TOKIN CORP), 24. Juli 1991 (1991-07-24)**

**Beschreibung**

Gebiet der Erfindung

Die vorliegende Erfindung betrifft ein Verfahren und eine Vorrichtung zur Messung eines in einem elektrischen Leiter fließenden Stroms.

Im Bereich der Fahrzeugtechnik führt die steigende Anzahl von elektrischen Verbrauchern in den Kraftfahrzeugen zu einem stetig steigenden Energiebedarf im Bordnetz. Hierdurch wird insbesondere die Bordbatterie immer stärker belastet, die während des Betriebs des Fahrzeugmotors als Puffer dient und im abgeschalteten Zustand des Motors die Spannungsversorgung des Fahrzeuges aufrecht erhält. Insbesondere bei vermehrtem Einsatz des Fahrzeugs im Kurzstreckenbereich kann dies dazu führen, dass die Batterie während des Betriebs des Motors nicht mehr vollständig geladen wird. Dies kann darin resultieren, dass das Fahrzeug mit entladener Batterie liegen bleibt oder sich aufgrund zu niedriger Batteriespannung nicht mehr starten lässt.

Um dies zu vermeiden, wird in Fahrzeugen zunehmend ein Energiemanagement eingesetzt. Ein solches Energiemanagement hat dafür zu sorgen, dass der Ladezustand der Batterie keinen kritischen Zustand erreicht und hat für eine positive Ladungsbilanz der Batterie zu sorgen. Grundlage für ein derartiges System bildet die Analyse des Batteriezustandes, der sich aus den Messgrößen Batteriestrom, Batteriespannung und Batterietemperatur ergibt. Hierbei ist vor allem die Erfassung des Lade- bzw. Entladestroms von entscheidender Bedeutung, um die Batterie auf einem unkritischen Ladeniveau zu halten und die Startfähigkeit des Fahrzeugs zu sichern.

Die Herausforderung bei der Erfassung des Lade- bzw. Entladestroms liegt darin, dass die zu messenden Ströme sich über einen sehr großen Bereich erstrecken, beispielsweise von -200 A bis 1500 A. Ein geeigneter Sensor für das Energiemanagement in Fahrzeugen muss entsprechend diesen weiten Bereich abdecken, also eine hohe Dynamik aufweisen.

Stand der Technik

In der Druckschrift WO 2005/005998 ist ein Messverfahren und eine Messanordnung zum Messen von Strömen mit großem Dynamikbereich mittels eines Kompensationsstromsensors beschrieben. Dabei wird ein Magnetkern durch Anlegen von Stromimpulsen an eine Kompensationsspule in eine erste und eine entgegen gesetzte zweite Richtung bis in die Sättigung getrieben und jeweils ein erster und zweiter Primärstromwert ermittelt. Ein korrigierter Primärstromwert wird durch Mittelwertbildung aus dem ersten und zweiten Primärstromwert berechnet.

Gemäß der Druckschrift US 5,475,301 werden zum Ermitteln eines Stroms durch einen elektrischen Leiter ein erster und ein zweiter jeweils mit einem Draht umwickelter Ringkern verwendet, wobei der elektrische Leiter und der zweite Ringkern durch den inneren Durchmesser des ersten Ringkerns verläuft. Zum Ermitteln des durch den elektrischen Leiter fließenden Stroms wird ein Wechselstrom zum periodischen und magnetischen Sättigen eines Teils des ersten und zweiten Ringkerns an den Draht, der den zweiten Ringkern anregt, angelegt.

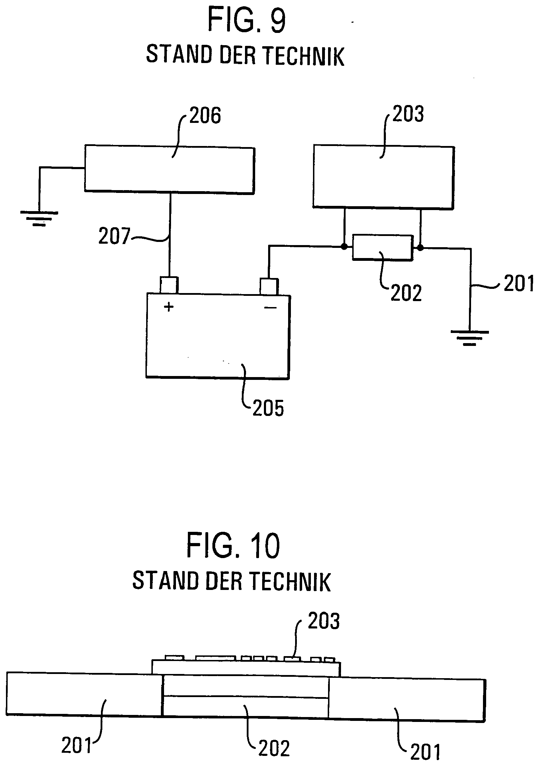

Aus dem Stand der Technik ist der in den Figuren 9 und 10 gezeigte Sensor zur Anwendung in einem Kraftfahrzeug zur Überwachung der fließenden Ströme bekannt. Zur Erfassung des Batteriestroms wird ein Messwiderstand 202 in die Masseleitung 201 eingefügt. Eine geeignete Auswerteelektronik 203 misst direkt den Spannungsabfall am Messwiderstand und berechnet hieraus den fließenden Strom. Der Messwiderstand kann dabei beispielsweise aus Manganin bestehen.

In Figur 9 ist der mit diesem Sensor zu realisierende Messaufbau gezeigt. Eine Autobatterie 205 ist über eine Masseleitung 202 mit der Fahrzeugmasse verbunden. Der Sensor bestehend aus dem Messwiderstand 202 und der Auswerteelektronik 203 sind in die Masseleitung 201 integriert. Elektrische Verbraucher 206 des Kraftfahrzeuges sind mit dem Pluspol der Batterie 205 über eine Leitung 207 verbunden.

Nachteilig an dieser aus dem Stand der Technik bekannten Lösung ist, dass der Messwiderstand in den stromführenden Leiter integriert werden muss, was einen zusätzlichen konstruktiven Aufwand verursacht, da sicherzustellen ist, dass Scher- und Zugkräfte vom Messwiderstand ferngehalten werden. Eine Verformung des Messwiderstandes kann das Messergebnis beeinflussen und führt im Extremfall zum Defekt des Sensors. Ein weiterer Nachteil ist, dass über dem Messwiderstand notwendig eine Verlustleistung abfällt. Auch bei Verwendung kleiner Widerstände, beispielsweise eines 100 $\mu\Omega$ Messwiderstandes fällt dennoch Verlustwärme ab, die abgeleitet werden muss.

Aufgabe der Erfindung

Ausgehend von diesem Stand der Technik ist es Aufgabe der vorliegenden Erfindung, ein Verfahren und eine Vorrichtung zur Messung eines in einem elektrischen Leiter fließenden Stroms anzugeben, die die Nachteile des Standes der Technik verringern und eine zuverlässige Messung eines Stromes in einem elektrischen Leiter über einen weiten Messbereich ermöglichen. Das Verfahren und die Vorrichtung soll insbesondere der Erfassung des Lade- und Entladestroms einer Batterie in einem Kraftfahrzeug dienen.

Beschreibung der Erfindung

Die Aufgabe wird durch ein Verfahren zur Messung eines in einem elektrischen Leiter fließenden Stroms nach Anspruch 1 sowie durch eine Vorrichtung zur Messung eines in einem elektrischen Leiter fließenden Stroms gemäß Anspruch 11 gelöst.

Zur Durchführung des Verfahrens wird ein im Bereich des elektrischen Leiters angeordneter Sensor zur Messung des den elektrischen Leiter umgebenden Magnetfeldes verwendet, wobei der Sensor einen Magnetkreis mit einem ersten und einem zweiten Abschnitt aufweist. Weiterhin ist eine Magnetisierungsvorrichtung zur magnetischen Sättigung des zweiten Abschnitts vorgesehen.

Der verwendete Sensor besitzt durch seinen speziellen Aufbau eine Messbereichsumschaltung, die in der Beschreibung der Figuren ausführlich dargestellt wird. Durch die Messbereichsumschaltung wird ein weiter Messbereich, also eine hohe Dynamik des Sensors erreicht. Diese hohe Dynamik geht allerdings mit systembedingten Messfehlern einher, die aus einer möglichen Hysterese des zweiten Abschnitts und einer möglichen Temperaturdrift einzelner Komponenten resultieren. Die nachfolgend angegebenen Verfahrensschritte ermöglichen eine Messung, die diese Messfehler eliminiert.

Erfindungsgemäß werden gemäß dem Verfahren die im folgenden beschriebenen Schritte durchgeführt. In einem ersten Schritt wird das Magnetfeld jeweils nach Abschalten sowohl einer positiven, als auch einer negativen Sättigung des zweiten Abschnitts gemessen und anschließend der Mittelwert aus den Messwerten berechnet. In einem zweiten Schritt wird das Magnetfeld sowohl bei positiver, als auch bei negativer Sättigung des zweiten Abschnitts gemessen und anschließend der Mittelwert aus den Messwerten berechnet. Nach Ermittlung der beiden Mittelwerte wird der durch den elektrischen Leiter fließende Strom durch Subtraktion des im zweiten Schritt berechneten Mittelwerts von dem im ersten Schritt berechneten Mittelwert berechnet und das Ergebnis mit einer Konstanten multipliziert. Die Reihenfolge des ersten und des zweiten Schritts kann dabei auch vertauscht sein.

Durch dieses Verfahren wird erreicht, dass mit einem potentialfreien Sensor der Strom in einem weiten Messbereich gemessen werden kann und dabei möglicherweise anfallende systembedingte Messfehler eliminiert werden können.

In einer vorteilhaften Ausgestaltung des Verfahrens wird im letzten Schritt die Konstante so gewählt, dass sie die Empfindlichkeit des Sensors sowohl bei gesättigtem als auch bei ungesättigtem zweitem Abschnitt berücksichtigt. Hierdurch kann aus den ermittelten Messwerten der den Leiter durchfließende Strom direkt angegeben werden.

Das bereits beschriebene Verfahren kann in einer weiteren Ausgestaltung mit den nachfolgend beschriebenen Schritten durchgeführt werden. In einem ersten Schritt wird der zweite Abschnitt positiv gesättigt und das Magnetfeld gemessen. In einem zweiten Schritt wird die Sättigung abgeschaltet und anschließend wiederum das Magnetfeld gemessen. In einem dritten Schritt wird der zweite Abschnitt negativ gesättigt und dann das Magnetfeld gemessen. In einem vierten Schritt wird nach dem Abschalten der Sättigung das Magnetfeld gemessen. In einem fünften Schritt wird dann der Mittelwert aus den in den Schritten zwei und vier gemessenen Werten gebildet und in einem sechsten Schritt der Mittelwert aus den in ersten und dritten Schritt gemessenen Werten. Im letzten Schritt wird dann der den Leiter durchfließende Strom durch Subtraktion des im siebten Schritt berechneten Mittelwerts von dem im sechsten Schritt berechneten Mittelwert und anschließender Multiplikation mit einer die Empfindlichkeit des Sensors bei gesättigtem und ungesättigtem zweiten Abschnitt berücksichtigenden Konstante berechnet.

Durch dieses Verfahren kann die für die Aufnahme der benötigten Messwerte benötigte Zeit abgekürzt werden.

Zur Überwachung eines Bordnetzes können die einzelnen Verfahrensschritte wiederholt ausgeführt werden, um den Stromverlauf über die Zeit zu ermitteln.

Die Ausführung des Verfahrens wird vereinfacht, wenn alle Schritte automatisch in einer Auswertungsvorrichtung ausgeführt werden. Diese Auswertungsvorrichtung gibt vorteilhaft nur den ermittelten Wert des Stroms aus und/oder stellt ihn zur Verfügung. Die Auswertungsvorrichtung steuert dabei mit Vorteil automatisch den Messvorgang, insbesondere das Ein- und Abschalten der Magnetisierungsvorrichtung.

Das beschriebene Verfahren kann in einem Fahrzeug, insbesondere in einem Kraftfahrzeug, ausgeführt werden, insbesondere zur Überwachung des Batteriestroms eines Fahrzeugs oder zur Überwachung einzelner Verbraucher oder Verbrauchergruppen.

Je nach verwendeten Materialien für die ersten und zweiten Abschnitte des Magnetkreises weist der erste Abschnitt eine erste Sättigungsmagnetisierung und der zweite Abschnitt eine zweite Sättigungsmagnetisierung auf, wobei die erste Sättigungsmagnetisierung kleiner, gleich oder größer als die zweite Sättigungsmagnetisierung ist. Auf diese Weise lassen sich die Parameter des Sensors durch die Wahl der jeweiligen Kombination von Sättigungsmagnetisierungen einstellen.

Die Vorrichtung zur Messung eines in einem elektrischen Leiter fließenden Stroms umfasst einen im Bereich des elektrischen Leiters angeordneten Sensor zur Messung des den elektrischen Leiter umgebenden Magnetfeldes.

Der Sensor weist dabei einen Magnetkreis mit einem ersten und einem zweiten Abschnitt auf und es ist eine Magnetisierungsvorrichtung zur Sättigung des zweiten Abschnitts vorgesehen. Eine Auswertungsvorrichtung zur Berechnung des den elektrischen Leiter durchfließenden Stroms in Abhängigkeit von Messwerten des den elektrischen Leiter umgebenden Magnetfeldes und in Abhängigkeit von der jeweiligen Magnetisierung des zweiten Abschnitts ist weiterhin vorgesehen.

Durch die Vorrichtung kann eine Strommessung in einem weiten Bereich vorgenommen werden, die ohne den Einfluss von möglichen systembedingten Messfehlern eine zuverlässige Messung ermöglicht.

Der Magnetkreis weist in einer Ausführungsform der Vorrichtung einen Luftspalt und ein in dem Luftspalt angeordnetes magnetfeldsensitives Bauteil, insbesondere einen Hall-Sensor, zur Messung des den elektrischen Leiter umgebenden Magnetfeldes auf.

Um eine genaue Erfassung des den elektrischen Leiter umgebenen Magnetfeldes zu erreichen, umgreift in einer bevorzugten Ausführungsform der Magnetkreis den elektrischen Leiter im Wesentlichen.

Eine einfache Anwendung der Vorrichtung wird in einer vorteilhaften Ausführung dadurch erreicht, dass die Auswertungsvorrichtung Mittel zur Durchführung, insbesondere zur automatischen Durchführung, des oben beschriebenen Verfahrens aufweist. Hierunter fallen insbesondere auch Mittel zur Steuerung der Magnetisierungsvorrichtung.

Durch Integration der Auswertungsvorrichtung mit dem Sensor kann eine kompakte Bauform erreicht werden. In einer anderen Ausführungsform kann durch räumliche Trennung von Auswertungsvorrichtung und Sensor eine hohe Flexibilität bei der Anordnung erreicht werden.

In einer vorteilhaften zweiten Ausführungsform des Sensors weist der erste Abschnitt des Magnetkreises mindestens zwei Schenkel auf, die einander überlappen und im Bereich der Überlappung einen Luftspalt ausbilden. Die Schenkel können dabei im Wesentlichen bogenförmig geformt sein, um ein Überspannen eines Stromleiters zu ermöglichen.

In der vorteilhaften zweiten Ausführungsform des Sensors kann weiterhin der zweite Abschnitt als rechteckiger Ferritkernrahmen ausgebildet sein, der auf mindestens einer Seite eine Steuerwicklung trägt. Mit Vorteil kann der Ferritkernrahmen jeweils eine Steuerwicklung auf jeder langen Seite des rechteckigen Ferritkernrahmens tragen, um eine symmetrische Konstruktion zu erreichen.

Zur Anwendung im Bereich der Bordnetzüberwachung kann der Sensor im Bereich eines Masseleiters oder eines Plusleiters einer Fahrzeugbatterie, insbesondere einer

Kraftfahrzeugbatterie, angeordnet sein, oder im Bereich eines elektrischen Verbrauchers oder einer Gruppe elektrischer Verbraucher eines Fahrzeugs, insbesondere eines Kraftfahrzeugs, angeordnet sein.

Das beschriebene Verfahren und die beschriebene Vorrichtung können in einem Kraftfahrzeug zur Überwachung von Strömen im Bordnetz verwendet werden.

Kurzbeschreibung der Zeichnungen

Die Erfindung wird nachfolgend an Hand bevorzugter Ausführungsformen beispielhaft beschrieben. Für gleiche Bauteile werden dabei einheitliche Bezugszeichen verwendet.

In den Zeichnungen zeigen:

Fig. 1     eine schematische Darstellung eines Stromsensors in einer ersten Ausführungsform;

Fig. 2     eine schematische Ansicht zweier Messkurven mit und ohne gesättigtem zweiten Abschnitt;

Fig. 3     eine schematische Ansicht der Ermittlung von Messpunkten in einem ersten Schritt;

Fig. 4     eine schematische Ansicht der Ermittlung von Messpunkten in einem zweiten Schritt;

Fig. 5     eine schematische Darstellung einer Anwendung der Vorrichtung in einem Bordnetz eines Kraftfahrzeugs, bei der die Vorrichtung direkt nach dem Pluspol angeordnet ist;

Fig. 6     eine schematische Ansicht einer Anwendung der Vorrichtung in einem Bordnetz eines Kraftfahrzeugs, bei der die Vorrichtung an der Masseleitung angebracht ist;

Fig. 7     eine schematische Seitenansicht eines Stromsensors in einer zweiten Ausführungsform;

Fig. 8     eine schematische Draufsicht auf den Stromsensor der Fig. 7;

Fig. 9     eine schematische Darstellung eines Sensors zur Batteriestrommessung gemäß dem Stand der Technik; und

Fig. 10    eine Schnittdarstellung des Messwiderstandes und der Auswerteelektronik aus der Fig. 8 gemäß dem Stand der Technik.

Ausführliche Beschreibung der Zeichnungen

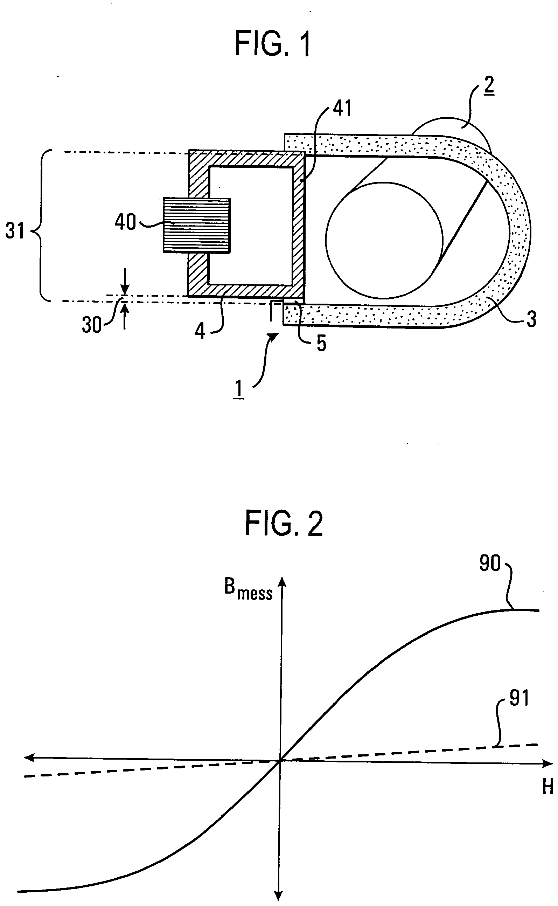

Fig. 1 zeigt schematisch eine mögliche erste Ausführungsform eines in der Vorrichtung verwendeten Sensors zur Messung eines den elektrischen Leiter umgebenden Magnetfeldes, der auch zur Durchführung des Verfahrens verwendet werden kann.

Der Sensor 1 wird zur Messung des Magnetfeldes, das den elektrischen Leiter 2 umgibt, wenn dieser von einem Strom durchflossen wird, verwendet. Der Sensor 1 weist hierzu einen Magnetkreis auf, der den elektrischen Leiter 2 im Wesentlichen umschließt. Der Magnetkreis weist einen ersten, im Wesentlichen U-förmigen Abschnitt 3 auf, der aus einem amorphen Material mit einer hohen Sättigungsmagnetisierung ausgebildet ist. Der Magnetkreis wird an der offenen Seite des ersten Abschnitts 3 bis auf einen Luftspalt 30 durch einen zweiten Abschnitt 41 des Magnetkreises geschlossen. Der zweite Abschnitt des Magnetkreises ist Teil eines geschlossenen, rahmenförmigen Ferritkerns 4, der eine niedrigere Sättigungsmagnetisierung aufweist, als der erste Abschnitt.

Der zwischen dem einen Schenkel des U-förmigen ersten Abschnitts 3 und dem Ende des zweiten Abschnitts 41 gebildete Luftspalt 30 wird vollständig durch einen Hallsensor 5 ausgefüllt. Der Hallsensor dient dabei zur Messung des den elektrischen Leiter umgebenden Magnetfeldes. Der dem zweiten Abschnitt 41 gegenüberliegende Schenkel des Ferritkerns 4 trägt eine Steuerwicklung 40, mit der der Ferritkern gesättigt werden kann.

Zur Anwendung des Sensors 1 über einen möglichst großen Messbereich, also mit einer möglichst hohen Dynamik, wird der Sensor wie folgt betrieben:
Bei kleinen Strömen wird der Sensor mit hoher Sensitivität betrieben. Hierzu wird der Ferritkern 4 ungesättigt betrieben, die Steuerwicklung 40 ist also stromlos. Der Magnetkreis besteht dann aus dem ersten Abschnitt 3 und dem zweiten Abschnitt 41. Nur der kleine Luftspalt 30, der mit dem Hallsensor 5 ausgefüllt ist, ist dabei vorgesehen. Auf diese Weise können kleine magnetische Felder bei Stromstärken von bis zu ca. 20 A gemessen werden.

Zur Messung hoher Ströme wird der Ferritkern 4 durch Aufbringen eines Magnetfelds mittels der Steuerwicklung 40 in Sättigung betrieben. Dadurch ist der Ferritkern 4 und damit auch der zweite Abschnitt 41 des Magnetkreises für den Magnetkreis nicht mehr wirksam. Der Luftspalt des Magnetkreises wird daher um die Schenkellänge des zweiten Abschnitts 41 vergrößert. Das im Magnetkreis gebundene Feld wird durch den nun großen Luftspalt 31 abgeschwächt, so dass die Sensitivität des Sensors 1 reduziert wird und mit dem Hallsensor 5 große Ströme erfasst werden können.

Fig. 2 zeigt beispielhaft Messkurven zur Verdeutlichung des Zusammenhangs. Auf der X-Achse ist hier das den elektrischen Leiter umgebende Magnetfeld H aufgetragen, das ebenso im Magnetkreis gebunden ist und das abhängig vom durch den elektrischen Leiter fließenden Strom $I_{DC}$ ist. Auf der Y-Achse ist das vom Hallsensor gemessene Magnetfeld B aufgetragen. Die durchgezogene Messkurve 90 zeigt dabei den Zusammenhang bei abgeschalteter Steuerwicklung 40, also bei kleinem Luftspalt. Hier ist eine hohe Sensitivität zu beobachten.

Die gestrichelte Linie 91 zeigt den Zusammenhang bei eingeschalteter Steuerwicklung 40, also bei großem Luftspalt. Hier wird eine niedrige Sensitivität des Messsensors beobachtet.

Der oben beschriebene Sensor 1 dient im Folgenden zur Erläuterung des der Anmeldung zu Grunde liegenden Verfahrens und der Vorrichtung.

Bei der Verwendung des beschriebenen Sensors ist zu beachten, dass die Hysterese des Ferritkerns 4 zu einem Fehler im Messergebnis führen kann. Weiterhin ist zu beachten, dass eine Temperaturdrift des Hallsensors sowie eine Langzeitdrift der übrigen Komponenten, aus welchen der Sensor aufgebaut ist, ebenfalls zu einer Verfälschung des Messsignals führen kann. Diese beiden möglichen Fehlerursachen können eine Nullpunktverschiebung ergeben, d.h. die jeweiligen Messkurven verlaufen nicht mehr durch den Ursprung des H/B Koordinatensystems. Zur Korrektur dieser möglichen Fehler dient unter anderem das im Folgenden beschriebene Verfahren.

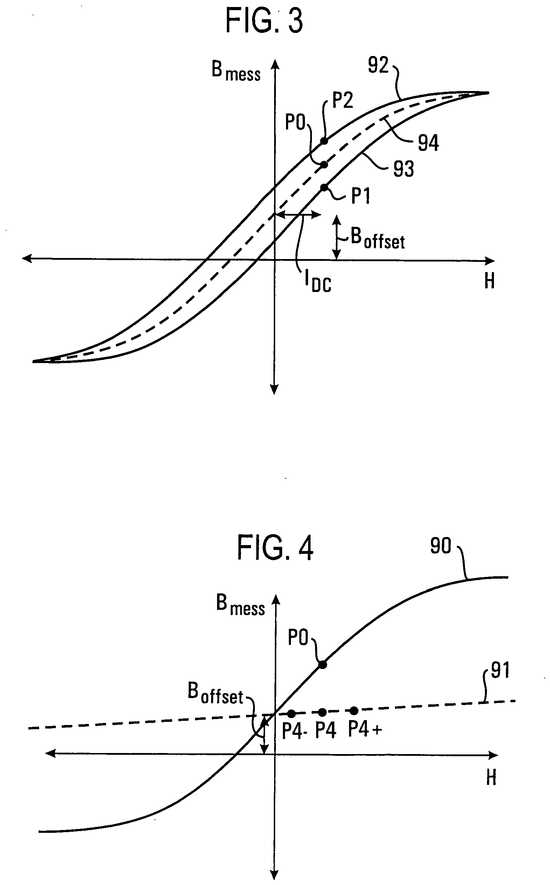

Im Folgenden wird angenommen, dass durch den elektrischen Leiter ein konstanter. Strom $I_{DC}$ fließt. Wie in Fig. 3 gezeigt, wird, um den Einfluss der Hysteresekurve des Ferritkerns 4 zu korrigieren, das B-Feld (Magnetfeld) der Punkte P1 und P2 gemessen. Dazu wird der Ferritkern 4 durch eine entsprechende Erregung der Steuerspule 40 positiv gesättigt. Nach Abschalten der Steuerspule 40 ergibt sich der Messpunkt B(P2). Danach wird durch eine entsprechende Bestromung der Steuerspule 40 der Ferritkern 4 negativ gesättigt, dann die Steuerspule abgeschaltet und der Messpunkt B(P1) gemessen. Durch eine einfache Mittelwertbildung erhält man den Mittelwert B(P0) aus den beiden Messpunkten B(P1) und B(P2). Der Mittelwert B(P0) liegt dann auf der "idealen" Magnetisierungskurve 94 des Ferritkerns.

Der Punkt B(P1) liegt auf dem unteren Ast 93 der Hysteresekurve, wohingegen der Messpunkt B(P2) auf dem oberen Ast 92 der Hysteresekurve liegt.

Die ideale Magnetisierungskurve 94 ist, wie aus der Fig. 3 zu erkennen ist, noch um einen Offset $B_{offset}$ verschoben, der durch Temperatureinflüsse oder durch eine allgemeine Bauteildrift hervorgerufen wird.

Der Mittelwert B(P0) kann durch die folgende Formel beschrieben werden:

$$B(P0) = S_{unsat} * I_{DC} + B_{Offset}$$

$S_{unsat}$ ist dabei die Empfindlichkeit des Sensors wenn der Ferritkern 4 ungesättigt ist, wenn also ein kleiner Luftspalt 30 vorgesehen ist.

Der in der Fig. 3 gezeigte Offsetfehler kann durch Ermittlung eines weiteren Punktes korrigiert werden. Die Ermittlung dieses weiteren Punktes B(P4) wird an Hand von Fig. 4 erläutert. In Fig. 4 ist die durchgezogenen Kurve 90 wieder die Kurve bei kleinem Luftspalt, also hoher Sensitivität des Sensors und die Kurve 91, die gestrichelt dargestellt ist, die Kurve bei großem Luftspalt, also niedriger Sensitivität des Sensors.

Die Messpunkte B(P4+) und B(P4-) werden nun gemessen, während der Ferritkern 4 gesättigt betrieben ist, also der Sensor mit niedriger Sensitivität betrieben wird. Der Messpunkt B(P4+) stellt sich dabei ein, wenn der Ferritkern 4 durch entsprechende Erregung der Steuerspule 40 positiv gesättigt ist. Der Messpunkt B(P4-) hingegen bei entsprechend negativer Sättigung des Ferritkerns 4. Bei dieser Messung muss beachtet werden, dass durch die Magnetisierung des Ferritkerns 4 ein positives bzw. negatives Streufeld hervorgerufen wird, das die jeweiligen Messergebnisse verfälscht. Durch die anschließende Mittelwertbildung der Messwerte B(P4+) und B(P4-) kürzt sich jedoch der Einfluss dieses Streufeldes heraus.

Auch dieser Mittelwert B(P4) ist noch um einen Fehler $B_{offset}$ verschoben. B(P4) kann durch folgende Formel angegeben werden:

$$B(P4) = S_{sat} * I_{DC} + B_{Offset}$$

$S_{sat}$ ist dabei die Empfindlichkeit des Sensors, wenn der Ferritkern 4 gesättigt ist, also ein großer Luftspalt 31 vorgesehen ist.

Die beiden berechneten Mittelwerte B(P0) und B(P4) sind nun beide jeweils noch mit dem Offsetfehler $B_{offset}$ beaufschlagt. Durch Subtraktion der berechneten Werte B(P0) - B(P4) kann dieser Offsetfehler $B_{offset}$ herausgerechnet werden. Das hieraus resultierende Ergebnis ist dann frei von Fehlereinflüssen. Die Rechnung geht dabei wie folgt von sich:

$$B(P0) - B(P4) = (S_{unsat} - S_{sat}) * I_{DC}$$

definiert man dabei

$$K = S_{sat}/S_{unsat}$$

so erhält man

$$B(P0) - B(P4) = S_{unsat} * (1 - K) * I_{DC}.$$

Der Strom kann hieraus wie folgt berechnet werden:

$$I_{DC} = (B(P0) - B(P4))/(S_{unsat} * (1 - K))$$

Durch dieses Verfahren ist es möglich, mit dem einleitend beschriebenen Sensor Ströme in einem weiten Messbereich fehlerfrei zu messen. Durch den beschriebenen Ansatz der potentialfreien Strommessung, die ohne das Einbringen eines Messwiderstandes in die jeweiligen stromführenden Leitungen auskommt, kann vor allem das Problem der Verlustleistung behoben werden.

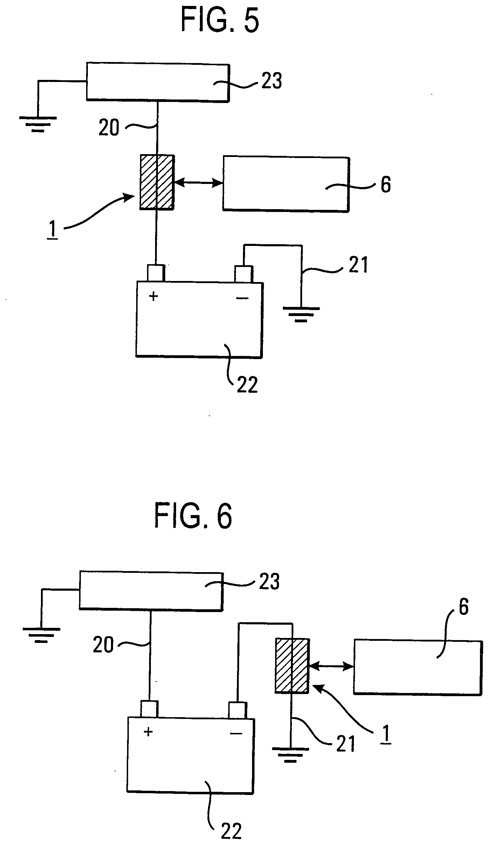

In Fig. 5 ist nun die Vorrichtung gezeigt, die sich aus dem Sensor 1 und der Auswertungsvorrichtung 6 zusammensetzt. Die Auswertungsvorrichtung 6 ist dabei so ausgebildet, dass sie zur Berechnung des den elektrischen Leiter durchfließenden Stroms Messwerte des Hallsensors 5 sowie Angaben zur jeweiligen Steuerspannung der Steuerspule 40 verarbeiten kann. Die Auswertevorrichtung 6 kann dabei in einer bevorzugten Ausführungsform auch das Verfahren steuern, also die Bestromung der Steuerspule 40 veranlassen und die Messwerte zum richtigen Zeitpunkt aufnehmen, speichern und verarbeiten. Hierzu kann die Auswertevorrichtung 6 ein in den Figuren nicht gezeigtes Interface aufweisen, das mit einem Verstärker zur Bestromung der Steuerspule 40 und mit der Hallsonde 5 in Verbindung steht. Weiterhin sind Mittel zur Speicherung der Messdaten vorgesehen. In einer bevorzugten Ausführungsform kann der Verstärker auch mit der Auswertungsvorrichtung integriert sein.

In Fig. 5 ist die Kombination aus Sensor 1 und Auswertungsvorrichtung 6 in die zu einem elektrischen Verbraucher 23 eines Fahrzeuges führende positive Leitung 20 eingebracht. Die positive Leitung 20 führt von einer Batterie 22 zum elektrischen Verbraucher 23. Die Masseleitung 21 ist mit dem Masseleiter des Fahrzeugs verbunden. Der Sensor 1 ist dabei direkt nach dem Pluspol der Batterie 22 angeordnet. Man spricht hier auch von einer "High-Side" Anordnung des Sensors.

In Fig. 6 ist die entsprechende Anordnung des Sensors 1 in die Masseleitung 21 des jeweiligen Bordstromkreises gezeigt. Hier spricht man auch von einer "Low-Side" Anordnung des Sensors.

Es ist möglich, den Sensor 1 mit der Auswertungsvorrichtung 6 zu einem Bauteil zu integrieren. Wenn dies auf Grund der beengten Verhältnisse im Motorraum nicht wünschenswert ist, kann die Auswertungsvorrichtung 6 auch separat vom Sensor 1 angeordnet werden.

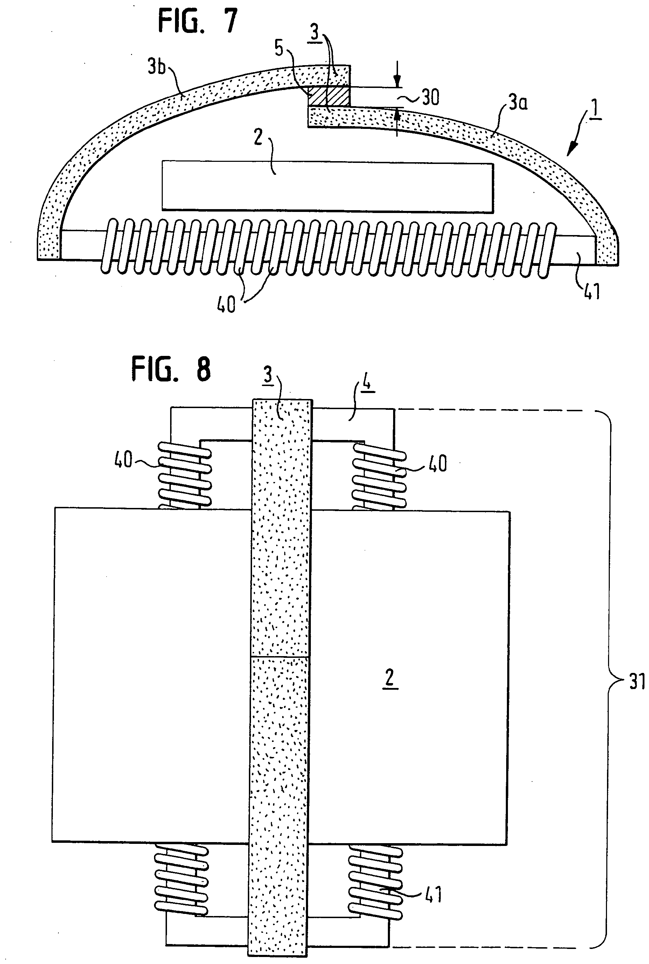

In Fig. 7 und Fig. 8 ist eine zweite Ausführungsform eines Stromsensors 1 gezeigt, mit dem das Verfahren durchgeführt werden kann und der in der Vorrichtung vorgesehen werden kann, wobei Fig. 7 eine Seitenansicht und Fig. 8 eine Draufsicht auf den Sensor zeigt.

Ein flacher elektrischer Leiter 2, beispielsweise ein Flachbandleiter, ein Blechleiter oder ein auf einer Leiterplatine vorgesehener Leiter wird von dem Sensor 1 umschlossen. Der Sensor 1 weist einen Magnetkreis auf, der aus einem ersten Abschnitt 3, der hier durch einen ersten Schenkel 3a und einen zweiten Schenkel 3b ausgebildet ist und einem zweiten Abschnitt 41 besteht. Die Schenkel 3a und 3b des ersten Abschnitts 3 überlappen einander im mittleren Bereich dieses Abschnitts, sind aber um einen Luftspalt 30 voneinander beabstandet. Um einen Leiter überspannen zu können, sind die Schenkel 3ä, 3b bogenförmig geformt und bilden gemeinsam einen Halbbogen aus. In diesem Luftspalt 30 ist ein Hallsensor 5 eingebracht, der zur Messung des im Magnetkreis vorhandenen Flusses dient.

Der zweite Abschnitt ist, wie in der Draufsicht zu erkennen, als rechteckiger Ferritkernrahmen 4 ausgeführt und trägt im Bereich 41 wiederum eine Magnetisierungsvorrichtung in Form von Steuerwicklungen 40, die jeweils auf den jeweiligen langen Seiten des rechteckigen Ferritkernrahmens 4 aufgebracht sind. Die unteren Schenkel des ersten Abschnitts sind mit diesem rechteckigen Ferritrahmen 4 im mittleren Bereich der kurzen Seiten des rechteckigen Ferritrahmens 4 verbunden.

Zur Messung geringer Ströme bleiben die Steuerwicklungen 40 stromlos. Zur Messung hoher Ströme wird der Ferritkernrahmen 4 durch Aufbringen eines Magnetfelds mittels der Steuerwicklungen 40 in Sättigung betrieben. Dadurch ist der Ferritkernrahmen 4 und damit auch der zweite Abschnitt 41 des Magnetkreises für den Magnetkreis nicht mehr wirksam. Der Luftspalt des Magnetkreises wird daher um die Schenkellänge des zweiten Abschnitts 41 vergrößert. Das im Magnetkreis gebundene Feld wird durch den zusätzlichen großen Luftspalt 31 abgeschwächt, so dass die Sensitivität des Sensors 1 reduziert wird und mit dem Hallsensor 5 große Ströme erfasst werden können. Der Gesamtluftspalt ist bei dieser zweiten Ausführungsform des Sensors die Summe des Luftspalts 30 des ersten Abschnitts 3 des Magnetkreises und des Luftspalts 31 des zweiten Abschnitts 41 des Magnetkreises.

Die Vorrichtung und das Verfahren können nicht nur der Überwachung des vollständigen Bordnetzes dienen, sondern können auch Stromwerte einzelner Verbraucher bzw. einzelner Verbrauchergruppen messen. Der Einsatz des Sensors ist in allen Fällen unabhängig von der jeweils anliegenden Spannung. Da es sich dabei auch um eine potentialfreie Messung handelt, ist auch eine Anwendung bei hohen Spannungen möglich. Ein universeller Einsatz der Vorrichtung zur Messung des Stromes ist damit möglich. Insbesondere ist auch ein Einsatz in Fahrzeugen mit einer höheren Bordnetzspannung, beispielsweise in Fahrzeugen mit einem Hybridantrieb möglich.

**Patentansprüche**

1. Verfahren zur Messung eines in einem elektrischen Leiter (2) fließenden Stroms mittels eines im Bereich des elektrischen Leiters angeordneten Sensors (1) zur Messung des den elektrischen Leiter umgebenden Magnetfeldes, wobei der Sensor einen Magnetkreis mit einem ersten (3) und einem zweiten (41) Abschnitt aufweist und eine Magnetisierungsvorrichtung (40) zur magnetischen Sättigung des zweiten Abschnitts vorgesehen ist, mit den folgenden Schritten:

   a. Messen des Magnetfeldes jeweils nach Abschalten sowohl einer positiven, als auch einer negativen magnetischen Sättigung des zweiten Abschnitts und anschließender Berechnung des Mittelwerts (B(P0)) aus den Messwerten (B(P1), B(P2)),
   b. Messen des Magnetfeldes sowohl bei positiver, als auch bei negativer magnetischer Sättigung des zweiten Abschnitts und anschließender Berechnung des Mittelwerts (B(P4)) aus den Messwerten (B(P4+), B(P4-)),
   c. Berechnung des durch den elektrischen Leiter fließenden Stromes durch Subtraktion des in Schritt b. berechneten Mittelwerts (B(P4)) von dem in Schritt a. berechneten Mittelwert (B(P0) und Multiplikation der Differenz mit einer Konstanten.

2. Verfahren nach Anspruch 1, **dadurch gekennzeichnet, dass** die Konstante in Schritt c. die Empfindlichkeit des Sensors sowohl bei magnetisch gesättigtem als auch bei magnetisch ungesättigtem zweitem Abschnitt berücksichtigt.

3. Verfahren nach Anspruch 1, **dadurch gekennzeichnet, dass** das in Anspruch 1 beanspruchte Verfahren mit den folgenden Schritten ausgeführt wird:

   a. Positive magnetische Sättigung des zweiten Abschnitts und Messen des Magnetfeldes (B(P4+)),
   b. Abschalten der magnetischen Sättigung des zweiten Abschnitts und anschließendes Messen des Magnetfeldes (B(P2)),
   c. Negative magnetische Sättigung des zweiten Abschnitts und Messen des Magnetfeldes (B(P4-)),
   d. Abschalten der magnetischen Sättigung des zweiten Abschnitts und anschließende Messung des Magnetfeldes (B(P1)),
   e. Berechnung des Mittelwerts (B(P0)) aus den in den Schritten b. und d. gemessenen Werten (B(P1), B(P2)),
   f. Berechnung des Mittelwertes (B(P4)) aus den in den Schritten a. und c. gemessenen Werten (B(P4+), B(P4-)),
   g. Berechung des den elektrischen Leiter durchfließenden Stromes ($I_{DC}$) durch Subtraktion des in Schritt f. berechneten Mittelwerts (B(P4)) von dem in Schritt e. berechneten Mittelwert (B(P0)) und anschließende Multiplikation mit einer die Empfindlichkeit des Sensors bei magnetisch gesättigtem und ungesättigtem zweiten Abschnitt berücksichtigenden Konstante ($1/S_{unsat}$ (1-K)).

4. Verfahren nach einem der vorstehenden Ansprüche, **dadurch gekennzeichnet, dass** die Verfahrensschritte wiederholt ausgeführt werden.

5. Verfahren nach einem der vorstehenden Ansprüche, **dadurch gekennzeichnet, dass** alle Schritte automatisch in einer Auswertungsvorrichtung (6) ausgeführt werden.

6. Verfahren nach Anspruch 5, **dadurch gekennzeichnet, dass** die Auswertungsvorrichtung nur den ermittelten Wert des Stroms ($I_{DC}$) ausgibt und/oder zur Verfügung stellt.

7. Verfahren nach Anspruch 5 oder 6, **dadurch gekennzeichnet, dass** die Auswertungsvorrichtung automatisch den Messvorgang steuert, insbesondere das Ein- und Abschalten der Magnetisierungsvorrichtung (40).

8. Verfahren nach einem der vorstehenden Ansprüche, **dadurch gekennzeichnet, dass** es in einem Fahrzeug, insbesondere in einem Kraftfahrzeug, ausgeführt wird.

9. Verfahren nach Anspruch 8, **dadurch gekennzeichnet, dass** es zur Überwachung des Batteriestroms eines Fahrzeugs oder zur Überwachung einzelner Verbraucher (23) oder Verbrauchergruppen in einem Fahrzeug dient.

10. Verfahren nach einem der vorstehenden Ansprüche, **dadurch gekennzeichnet, dass** der erste Abschnitt eine erste Sättigungsmagnetisierung und der zweite Abschnitt eine zweite Sättigungsmagnetisierung aufweist und die erste Sättigungsmagnetisierung größer, kleiner oder gleich der zweiten Sättigungsmagnetisierung ist.

11. Vorrichtung zur Messung eines in einem elektrischen Leiter (2) fließenden Stroms mit einem im Bereich des elektrischen Leiters angeordneten Sensor (1) zur Messung des den elektrischen Leiter umgebenden Magnetfeldes, wobei der Sensor einen Magnetkreis mit einem ersten (3) und einem zweiten (41) Abschnitt aufweist, eine Magnetisierungsvorrichtung (40) zur magnetischen Sättigung des zweiten Abschnitts vorgesehen ist und weiterhin eine Auswertungsvorrichtung (6) zur Berechnung des den elektrischen Leiter durchfließenden Stroms in Abhängigkeit von Messwerten (B(P0), B(P1), B(P2)), B(P4), B(P4+), B(P4-)) des den elektrischen Leiter umgebenden Magnetfeldes und in Abhängigkeit von der jeweiligen Magnetisierung des zweiten Abschnitts vorgesehen ist, wobei die Auswertungsvorrichtung (6) zur Durchführung der folgenden Schritte ausgebildet ist:

   a. Messen des Magnetfeldes jeweils nach Abschalten sowohl einer positiven, als auch einer negativen magnetischen Sättigung des zweiten Abschnitts und anschließender Berechnung des Mittelwerts (B(P0)) aus den Messwerten (B(P1), B(P2)),
   b. Messen des Magnetfeldes sowohl bei positiver, als auch bei negativer magnetischer Sättigung des zweiten Abschnitts und anschließender Berechnung des Mittelwerts (B(P4)) aus den Messwerten (B(P4+), B(P4-)),
c. Berechnung des durch den elektrischen Leiter fließenden Stromes durch Subtraktion des in Schritt b. berechneten Mittelwerts (B(P4)) von dem in Schritt a. berechneten Mittelwert (B(P0)) und Multiplikation der Differenz mit einer Konstanten.

**12.** Vorrichtung nach Anspruch 11, **dadurch gekennzeichnet, dass** der Magnetkreis einen Luftspalt (30, 31) und ein in dem Luftspalt angeordnetes magnetfeldsensitives Bauteil (5), insbesondere ein Hall-Sensor, zur Messung des den elektrischen Leiter umgebenden Magnetfeldes aufweist.

**13.** Vorrichtung nach Anspruch 11 oder 12, **dadurch gekennzeichnet, dass** der Magnetkreis den elektrischen Leiter im Wesentlichen umgreift.

**14.** Vorrichtung nach einem der Ansprüche 11 bis 13, **dadurch gekennzeichnet, dass** die Auswertungsvorrichtung Mittel zur Durchführung, insbesondere zur automatischen Durchführung, der Schritte a. bis c. aufweist.

**15.** Vorrichtung nach Anspruch 14, **dadurch gekennzeichnet, dass** die Auswertungsvorrichtung Mittel zur Steuerung der Magnetisierungsvorrichtung (40) aufweist.

**16.** Vorrichtung nach einem der Ansprüche 11 bis 15, **dadurch gekennzeichnet, dass** die Auswertungsvorrichtung mit dem Sensor integriert ist.

**17.** Vorrichtung nach einem der Ansprüche 11 bis 15, **dadurch gekennzeichnet, dass** die Auswertungsvorrichtung und der Sensor räumlich voneinander getrennt angeordnet sind.

**18.** Vorrichtung nach einem der Ansprüche 11 bis 17, **dadurch gekennzeichnet, dass** der Sensor im Bereich eines Masseleiters (21) oder eines Plusleiters (20) einer Fahrzeugbatterie (22), insbesondere einer Kraftfahrzeugbatterie, angeordnet ist.

**19.** Vorrichtung nach einem der Ansprüche 11 bis 18, **dadurch gekennzeichnet, dass** der Sensor im Bereich eines elektrischen Verbrauchers (23) oder einer Gruppe elektrischer Verbraucher eines Fahrzeugs, insbesondere eines Kraftfahrzeugs, angeordnet ist.

**20.** Vorrichtung nach einem der Ansprüche 11 bis 19, **dadurch gekennzeichnet, dass** der erste Abschnitt eine erste Sättigungsmagnetisierung und der zweite Abschnitt eine zweite Sättigungsmagnetisierung aufweist und die erste Sättigungsmagnetisierung größer, kleiner oder gleich der zweiten Sättigungsmagnetisierung ist.

**21.** Vorrichtung nach einem der Ansprüche 11 bis 20, **dadurch gekennzeichnet, dass** der erste Abschnitt (3) des Magnetkreises mindestens zwei Schenkel (3a, 3b) aufweist, die einander überlappen und im Bereich der Überlappung einen Luftspalt (30) ausbilden.

**22.** Vorrichtung nach Anspruch 21, **dadurch gekennzeichnet, dass** die Schenkel (3a, 3b) im Wesentlichen bogenförmig geformt sind.

**23.** Vorrichtung nach einem der Ansprüche 11 bis 22, **dadurch gekennzeichnet, dass** der zweite Abschnitt (41) als rechteckiger Ferritkernrahmen (4) ausgebildet ist, der auf mindestens einer Seite eine Steuerwicklung (40) trägt.

**24.** Vorrichtung nach Anspruch 23, **dadurch gekennzeichnet, dass** der Ferritkernrahmen (4) jeweils eine Steuerwicklung (40) auf jeder langen Seite des rechteckigen Ferritkernrahmens (4) trägt.

**25.** Vorrichtung nach Anspruch 23 oder 24, **dadurch gekennzeichnet, dass** der erste Abschnitt (3) im mittleren Bereich der kurzen Seiten des rechteckigen Ferritkernrahmens (4) verbunden ist.

**26.** Verwendung einer Vorrichtung gemäß einem der Ansprüche 11 bis 25 in einem Kraftfahrzeug zur Überwachung von Strömen im Bordnetz des Kraftfahrzeugs.

**27.** Verwendung eines Verfahrens gemäß einem der Ansprüche 1 bis 10 in einem Kraftfahrzeug zur Überwachung von Strömen im Bordnetz des Kraftfahrzeugs.

**Claims**

1. Method for measuring a current flowing in an electrical conductor (2) by means of a sensor (1), which is arranged in the region of the electrical conductor and serves for measuring the magnetic field surrounding the electrical conductor, wherein the sensor has a magnetic circuit having a first (3) and a second (41) section and a magnetization apparatus (40) is provided for the magnetic saturation of the second section, said method having the following steps:

   a. measurement of the magnetic field in each case after switching off both a positive and a negative magnetic saturation of the second section and subsequent calculation of the average value (B(P0)) from the measurement values (B(P1), B(P2)),
   b. measurement of the magnetic field both in the case of positive and in the case of negative magnetic saturation of the second section and subsequent calculation of the average value (B(P4)) from the measurement values (B(P4+), B(P4-)),
   c. calculation of the current flowing through the electrical conductor by subtraction of the average value (B(P4)) calculated in step b. from the average value (B(P0)) calculated in step a. and multiplication of the difference by a constant.

2. Method according to Claim 1, **characterized in that** the constant in step c. takes into account the sensitivity of the sensor both in the case of a magnetically saturated and in the case of a magnetically unsaturated second section.

3. Method according to Claim 1, **characterized in that** the method claimed in Claim 1 is executed using the following steps:

   a. positive magnetic saturation of the second section and measurement of the magnetic field (B(P4+)),
   b. switch-off of the magnetic saturation of the second section and subsequent measurement of the magnetic field (B(P2)),
   c. negative magnetic saturation of the second section and measurement of the magnetic field (B(P4-)),
   d. switch-off of the magnetic saturation of the second section and subsequent measurement of the magnetic field (B(P1)),
   e. calculation of the average value (B(P0)) from the values (B(P1), B(P2)), measured in steps b. and d.,
   f. calculation of the average value (B(P4)) from the values (B(P4+), B(P4-)) measured in steps a. and c.,
   g. calculation of the current ($I_{DC}$) flowing through the electrical conductor by subtraction of the average value (B(P4)) calculated in step f. from the average value (B(P0)) calculated in step e. and subsequent multiplication by a constant ($1/S_{unsat}$ (1-K)), which constant takes into account the sensitivity of the sensor in the case of a magnetically saturated and unsaturated second section.

4. Method according to one of the preceding claims, **characterized in that** the method steps are executed repeatedly.

5. Method according to one of the preceding claims, **characterized in that** all of the steps are executed automatically in an evaluation apparatus (6).

6. Method according to Claim 5, **characterized in that** the evaluation apparatus outputs and/or provides only the determined value of the current ($I_{DC}$).

7. Method according to Claim 5 or 6, **characterized in that** the evaluation apparatus controls the measurement process automatically, in particular the switch-on and switch-off of the magnetization apparatus (40).

8. Method according to one of the preceding claims, **characterized in that** said method is executed in a vehicle, in particular in a motor vehicle.

9. Method according to Claim 8, **characterized in that** said method serves to monitor the battery current of a vehicle or to monitor individual loads (23) or groups of loads in a vehicle.

10. Method according to one of the preceding claims, **characterized in that** the first section has a first saturation magnetization and the second section has a second saturation magnetization and the first saturation magnetization is greater than, less than or equal to the second saturation magnetization.

11. Apparatus for measuring a current flowing in an electrical conductor (2), said apparatus having a sensor (1), which is arranged in the region of the electrical conductor and serves for measuring the magnetic field surrounding the electrical conductor, wherein the sensor has a magnetic circuit having a first (3) and a second (41) section, a magnetization apparatus (40) is provided for the magnetic saturation of the second section and an evaluation apparatus (6) for calculating the current flowing through the electrical conductor depending on measurement values (B(P0), B(P1), B(P2), B(P4), B(P4+), B(P4-)) of the magnetic field surrounding the electrical conductor and depending on the respective magnetization of the second section is also provided, wherein the evaluation apparatus (6) is configured to carry out the following steps:

a. measurement of the magnetic field in each case after switching off both a positive and a negative magnetic saturation of the second section and subsequent calculation of the average value (B(P0)) from the measurement values (B(P1), B(P2)),

b. measurement of the magnetic field both in the case of positive and in the case of negative magnetic saturation of the second section and subsequent calculation of the average value (B(P4)) from the measurement values (B(P4+), B(P4-)),

c. calculation of the current flowing through the electrical conductor by subtraction of the average value (B(P4)) calculated in step b. from the average value (B(P0)) calculated in step a. and multiplication of the difference by a constant.

12. Apparatus according to Claim 11, **characterized in that** the magnetic circuit has an air gap (30, 31) and a magnetic-field-sensitive component (5) arranged in the air gap, in particular a Hall sensor, for measuring the magnetic field surrounding the electrical conductor.

13. Apparatus according to Claim 11 or 12, **characterized in that** the magnetic circuit substantially encompasses the electrical conductor.

14. Apparatus according to one of Claims 11 to 13, **characterized in that** the evaluation apparatus has means for carrying out, in particular for automatically carrying out, steps a. to c.

15. Apparatus according to Claim 14, **characterized in that** the evaluation apparatus has means for controlling the magnetization apparatus (40).

16. Apparatus according to one of Claims 11 to 15, **characterized in that** the evaluation apparatus is integrated with the sensor.

17. Apparatus according to one of Claims 11 to 15, **characterized in that** the evaluation apparatus and the sensor are arranged in a manner spatially separated from one another.

18. Apparatus according to one of Claims 11 to 17, **characterized in that** the sensor is arranged in the region of an earth conductor (21) or of a positive conductor (20) of a vehicle battery (22), in particular of a motor vehicle battery.

19. Apparatus according to one of Claims 11 to 18, **characterized in that** the sensor is arranged in the region of an electrical load (23) or of a group of electrical loads of a vehicle, in particular of a motor vehicle.

20. Apparatus according to one of Claims 11 to 19, **characterized in that** the first section has a first saturation magnetization and the second section has a second saturation magnetization and the first saturation magnetization is greater than, less than or equal to the second saturation magnetization.

21. Apparatus according to one of Claims 11 to 20, **characterized in that** the first section (3) of the magnetic circuit has at least two limbs (3a, 3b), which overlap one another and form an air gap (30) in the region of the overlap.

22. Apparatus according to Claim 21, **characterized in that** the limbs (3a, 3b) are formed in a substantially arc-shaped manner.

23. Apparatus according to one of Claims 11 to 22, **characterized in that** the second section (41) is designed as a rectangular ferrite core frame (4), which bears a control winding (40) on at least one side.

24. Apparatus according to Claim 23, **characterized in that** the ferrite core frame (4) bears in each case a control winding (40) on each long side of the rectangular ferrite core frame (4).

25. Apparatus according to Claim 23 or 24, **characterized in that** the first section (3) is connected in the central region of the short sides of the rectangular ferrite core frame (4).

26. Use of an apparatus according to one of Claims 11 to 25 in a motor vehicle for monitoring currents in the on-board power supply system of the motor vehicle.

27. Use of a method according to one of Claims 1 to 10 in a motor vehicle for monitoring currents in the on-board power supply system of the motor vehicle.

**Revendications**

1. Procédé, destiné à mesurer un courant passant dans un conducteur électrique (2), au moyen d'un capteur (1) placé dans la région du conducteur électrique, pour la mesure du champ magnétique qui entoure le conducteur électrique, le capteur comportant un circuit magnétique doté d'un premier (3) et d'un deuxième (41) segments et un dispositif d'aimantation (40) pour la saturation magnétique du deuxième segment étant prévu, comportant les étapes suivantes, consistant à :

   a. mesurer le champ magnétique, chaque fois après la mise à l'arrêt, aussi bien d'une saturation positive que négative du deuxième segment et à calculer consécutivement calcul la valeur moyenne (B(P0)), à partir des valeurs mesurées (B(P1), B (P2)),
   b. mesurer le champ magnétique, aussi bien dans le cas d'une saturation magnétique positive que négative du deuxième segment et à calculer consécutivement la valeur moyenne (B(P4)), à partir des valeurs mesurées (B(P4+), B(P4-)),
   c. calculer le courant circulant à travers le conducteur électrique par soustraction de la valeur moyenne (B(P4)) obtenue dans l'étape b. de la valeur moyenne (B(P0) calculée dans l'étape a. et à multiplier la différence avec une constante.

2. Procédé selon la revendication 1, **caractérisé en ce que** la constante dans l'étape c. prend en considération la sensibilité du capteur, aussi bien lorsque le deuxième segment est magnétiquement saturé, que lorsque le deuxième segment est magnétiquement insaturé.

3. Procédé selon la revendication 1, **caractérisé en ce que** le procédé revendiqué dans la revendication 1 est réalisé avec les étapes suivantes, consistant dans :

   a. la saturation magnétique positive du deuxième et dans la mesure du champ magnétique (B(P4+)),
   b. la mise à l'arrêt de la saturation magnétique du deuxième segment et la mesure consécutive du champ magnétique (B(P2)),
   c. la saturation magnétique négative du deuxième segment et la mesure du champ magnétique (B(P4-)),
   d. la mise à l'arrêt de la saturation magnétique du deuxième segment et la mesure consécutive du champ magnétique (B(P1)),
   e. le calcul de la valeur moyenne (B(P0)) à partir des valeurs (B(P1), B(P2)) mesurées dans les étapes b. et d.,
   f. le calcul de la valeur moyenne (B(P4)) des valeurs (B(P4+), B(P4-)) obtenues dans les étapes a. et c.,
   g. le calcul du courant ($I_{DC}$) circulant à travers le conducteur électrique par soustraction de la valeur moyenne (B(P4)) calculée dans l'étape f. de la valeur moyenne (B(P0)) calculée dans l'étape e. et la multiplication consécutive avec une constante ($1/S_{unsat}$ (1-K)) (B(P0)) tenant compte de la sensibilité du capteur, lorsque le deuxième segment est magnétiquement saturé et magnétiquement insaturé.

4. Procédé selon l'une quelconque des revendications précédentes, **caractérisé en ce que** les étapes de procédé sont réalisées de manière répétitive.

5. Procédé selon l'une quelconque des revendications précédentes, **caractérisé en ce que** toutes les étapes sont réalisées automatiquement dans un dispositif d'évaluation (6).

6. Procédé selon la revendication 5, **caractérisé en ce que** le dispositif d'évaluation n'édite ou ne met à disposition que la valeur déterminée du courant ($I_{DC}$) .

7. Procédé selon la revendication 5 ou 6, **caractérisé en ce que** le dispositif d'évaluation commande automatiquement le processus de mesure, notamment la mise en route et à l'arrêt du dispositif d'aimantation (40).

8.  Procédé selon l'une quelconque des revendications précédentes, **caractérisé en ce qu'**il est réalisé dans un véhicule, notamment dans un véhicule automatique.

9.  Procédé selon la revendication 8, **caractérisé en ce qu'**il est destiné à la supervision du courant de batterie d'un véhicule ou à la supervision de consommateurs (23) individuels ou de groupes de consommateurs.

10. Procédé selon l'une quelconque des revendications précédentes, **caractérisé en ce que** le premier tronçon fait preuve d'une première aimantation de saturation et **en ce que** le deuxième tronçon fait preuve d'une deuxième aimantation de saturation et **en ce que** la première aimantation de saturation est supérieure, inférieure ou égale à la deuxième aimantation de saturation.

11. Dispositif, destiné à mesurer un courant circulant dans un conducteur électrique (2), pourvu d'un capteur (1) placé dans la région du conducteur électrique, destiné à mesurer le champ magnétique entourant le conducteur électrique, le capteur comportant un circuit magnétique doté d'un premier (3) et d'un deuxième (41) segments, d'un dispositif d'aimantation (40), destiné à la saturation magnétique du deuxième segment et par ailleurs le dispositif d'évaluation (6) étant conçu pour le champ magnétique destiné à calculer le courant passant par ailleurs par l'intermédiaire du conducteur électrique en fonction de valeurs de mesure (B(PO), B(P1), B(P2)), B(P4), B(P4+), B(P4-)) du champ magnétique entourant le conducteur électrique et en fonction de l'aimantation respective du deuxième segment, le dispositif d'évaluation (6) étant conçu pour réaliser les étapes suivantes, consistant à :

    a. mesurer le champ magnétique, chaque fois après la mise à l'arrêt, aussi bien d'une saturation magnétique positive que négative du deuxième segment et à calculer consécutivement la valeur moyenne (B(PO)) à partir des valeurs mesures (B(P1), B(P2)),
    b. mesurer le champ magnétique, aussi bien à saturation magnétique positive que négative des deux segments et à calculer consécutivement la valeur moyenne (B(P4)) à partir des valeurs de mesure (B(P4+), (B(P4-)),
    c. calculer le courant circulant à travers le conducteur électrique, par soustraction de la valeur moyenne (B(P4)) calculée dans l'étape a. de la valeur moyenne (B(PO) calculée dans l'étape b. et par multiplication de la différence avec une constante.

12. Dispositif selon la revendication 11, **caractérisé en ce que** le circuit magnétique comporte un entrefer (30, 31) et un composant (5) sensible au champ magnétique, placé dans l'entrefer, notamment un capteur de Hall destiné à mesurer le champ magnétique entourant le conducteur électrique.

13. Dispositif selon la revendication 11 ou 12, **caractérisé en ce que** le circuit magnétique enveloppe sensiblement le conducteur électrique.

14. Dispositif selon l'une quelconque des revendications 11 à 13, **caractérisé en ce que** le dispositif d'évaluation comporte des moyens, destinés à réaliser, notamment à réaliser automatiquement les étapes a. à c.

15. Dispositif selon la revendication 14, **caractérisé en ce que** le dispositif d'évaluation comporte des moyens destinés à commander le dispositif d'aimantation (40).

16. Dispositif selon l'une quelconque des revendications 11 à 15, **caractérisé en ce que** le dispositif d'évaluation est intégré avec le capteur.

17. Dispositif selon l'une quelconque des revendications 11 à 15, **caractérisé en ce que** le dispositif d'évaluation et le capteur sont conçus en étant séparés l'un de l'autre dans l'espace.

18. Dispositif selon l'une quelconque des revendications 11 à 17, **caractérisé en ce que** le capteur est placé dans la région d'un conducteur de masse (21) ou d'un conducteur positif (20) d'une batterie de véhicule (22), notamment d'une batterie de véhicule automobile.

19. Dispositif selon l'une quelconque des revendications 11 à 18, **caractérisé en ce que** le capteur est placé dans la région d'un consommateur (23) électrique ou d'un groupe de consommateurs électriques d'un véhicule, notamment d'un véhicule automobile.

**20.** Dispositif selon l'une quelconque des revendications 11 à 19, **caractérisé en ce que** le premier segment présente une première aimantation de saturation et le deuxième segment présente une deuxième aimantation de saturation et **en ce que** la première aimantation de saturation est supérieure, inférieure ou égale à la deuxième aimantation de saturation.

**21.** Dispositif selon l'une quelconque des revendications 11 à 20, **caractérisé en ce que** le premier segment (3) du circuit magnétique comporte au moins deux branches (3a, 3b) qui se chevauchent mutuellement et qui dans la région du chevauchement forment un entrefer (30).

**22.** Dispositif selon la revendication 21, **caractérisé en ce que** les branches (3a, 3b) sont façonnées sensiblement en forme d'arc.

**23.** Dispositif selon l'une quelconque des revendications 11 à 22, **caractérisé en ce que** le deuxième segment (41) est conçu sous la forme d'un cadre (4) à noyau de ferrite rectangulaire qui au moins sur un côté porte un enroulement de commande (40) .

**24.** Dispositif selon la revendication 23, **caractérisé en ce que** le cadre (4) à noyau de ferrite comporte respectivement un enroulement de commande (40) sur chaque côté longitudinal du cadre (4) à noyau de ferrite rectangulaire.

**25.** Dispositif selon la revendication 23 ou 24, **caractérisé en ce que** le premier segment (3) est assemblé dans la zone centrale des côtés étroits du cadre (4) à noyau de ferrite rectangulaire.

**26.** Utilisation d'un dispositif selon l'une quelconque des revendications 11 à 25 dans un véhicule automobile, pour la supervision de courants dans le réseau de bord d'un véhicule automobile.

**27.** Utilisation d'un procédé selon l'une quelconque des revendications 1 à 10 dans un véhicule automobile, pour la supervision de courants dans le réseau de bord du véhicule.

# FIG. 1

# FIG. 2

## FIG. 3

## FIG. 4

## FIG. 5

## FIG. 6

EP 1 726 967 B1

## FIG. 7

## FIG. 8

## FIG. 9
### STAND DER TECHNIK

## FIG. 10
### STAND DER TECHNIK

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2005005998 A
- US 5475301 A